Europäisches Patentamt

European Patent Office

Office européen des brevets

(11) Numéro de publication : **0 312 447 B1**

(12) **FASCICULE DE BREVET EUROPEEN**

(45) Date de publication du fascicule du brevet :
29.07.92 Bulletin 92/31

(51) Int. Cl.⁵ : **C23C 16/50, C23C 16/46**

(21) Numéro de dépôt : **88402570.1**

(22) Date de dépôt : **11.10.88**

(54) **Procédé et appareil pour la production par plasma de couches minces à usage électronique et/ou optoélectronique.**

(30) Priorité : **15.10.87 FR 8714245**

(43) Date de publication de la demande :
**19.04.89 Bulletin 89/16**

(45) Mention de la délivrance du brevet :
**29.07.92 Bulletin 92/31**

(84) Etats contractants désignés :
**AT BE CH DE ES FR GB GR IT LI LU NL SE**

(56) Documents cités :
**EP-A- 0 221 812
WO-A-87/01738
WO-A-87/04733**

(73) Titulaire : **SOLEMS S.A. Société dite:**
**3, rue Léon Blum Z.I. Les Glaises**
**F-92120 Palaiseau (FR)**

(72) Inventeur : **Schmitt, Jacques**
**51, Grande Rue**
**F-91620 La Ville du Bois (FR)**

(74) Mandataire : **Lerner, François**
**LERNER & BRULLE S.C.P. 5, rue Jules Lefèbvre**
**F-75009 Paris (FR)**

Jouve, 18, rue Saint-Denis, 75001 PARIS

# Description

L'invention concerne un procédé pour conduire un appareil destiné à produire toutes sortes de couches minces à usage électronique et/ou optoélectronique telles notamment que des couches minces semi-conductrices amorphes ou cristallines, à l'aide d'un processus de dépôt par plasma.

L'invention se rapporte également à l'appareil en lui-même.

On connaît déjà, en se référant notamment à la demande de brevet FR-A-2 589 168, déposée le 25 octobre 1985 par le présent demandeur, des appareils de cette catégorie comprenant :

– une enceinte dans laquelle règne une pression inférieure à la pression atmosphérique,

– des moyens pour créer une zone de plasma dans l'enceinte, ces moyens comprenant au moins une électrode reliée à une source de puissance électrique, au moins un substrat et des moyens pour introduire des gaz réactifs dans la zone de plasma,

– des moyens pour évacuer vers l'extérieur de l'enceinte une partie résiduelle des gaz réactifs après séjour dans la zone de plasma,

– et une chambre étanche dans laquelle est logée ladite enceinte et où règne une pression inférieure à celle de l'enceinte.

Malgré les avantages procurés par l'évacuation de la partie résiduelle des gaz réactifs et par le différentiel de pression établi entre la chambre extérieure et l'enceinte de dépôt, ce type d'appareil n'est cependant pas apparu, en l'état, comme susceptible de limiter suffisamment les problèmes de contamination ou d'altération des propriétés électroniques des matériaux en formation.

En effet, si l'aspiration vers l'extérieur de la zone de dépôt d'une partie importante des impuretés présentes dans son atmosphère s'est avérée efficace, le problème de base relatif à la formation des flux de matières contaminantes provoqués essentiellement, compte tenu des conditions de fonctionnement de l'appareil, par l'émission gazeuse des parois de l'enceinte (mais également des substrats et autres supports), lesquelles parois adsorbent une multitude de molécules, n'a pas été élucidé.

Or, il est apparu que la "décomposition" de surface, ou dégazage, des éléments constitutifs de l'appareil à proximité de cette zone de dépôt (appelée aussi zone de plasma) pouvaient venir altérer les propriétés électroniques des semi-conducteurs, cette situation étant aggravée de par la nature en fait "semi-étanche" de l'enceinte intérieure de réaction dont les plaques porte-substrats sur lesquelles sont montés les substrats, viennent simplement prendre appui, de façon non-étanche, vers leur extrémité périphérique, sur des parois latérales de l'enceinte, lesquelles parois latérales sont raccordées, de façon étanche, à des parois de fermeture avant et arrière de cette même enceinte, elles-mêmes raccordées, également de façon étanche, aux conduits respectivement d'admission des gaz réactifs et d'évacuation de la partie résiduelle non déposée de ces mêmes gaz.

Il a été remarqué que du fait de cette étanchéité incomplète dans le montage des porte-substrats et malgré la mise en dépression de la chambre extérieure étanche par rapport à l'enceinte de réaction, certaines impuretés provenant essentiellement du dégazage des parois de la chambre avaient tendance à cheminer à contre-courant du flux d'aspiration de l'enceinte vers cette même chambre et à pénétrer dans l'enceinte, nuisant également à la qualité des matériaux en formation.

Ces problèmes d'altération de la pureté chimique des matériaux produits ont été résolus, conformément au procédé de la présente invention, en prévoyant tout d'abord sur la base de l'enseignement du document FR-A-2 589 168 (voir préambule de la revendication 1), de venir chauffer les parois de l'enceinte intérieure tout en maintenant les parois de la chambre extérieure à une température inférieure à celle de l'enceinte.

Conformément à l'invention, et comme mentionné en revendication 5, des moyens ont été également prévus pour mener à bien ces étapes de procédé.

En effet, il est apparu que le fait de chauffer les parois de l'enceinte de réaction pendant, et de préférence avant, la phase de dépôt des couches, a priori entre 150 et 250°C (pouvant aller jusqu'à 350°C au cours du préchauffage) permettait de limiter largement la diffusion par dégazage des matières contaminantes dans ou à proximité de l'atmosphère de l'enceinte, facilitant donc l'évacuation de ces matières tout en réduisant le risque de leur pénétration à contre-courant par les interstices de fuite des porte-substrats.

Au document WO-87/04 738, on notera qu'il était déjà prévu, sur certains appareils de traitement thermochimique ou de dépôt chimique sous plasma, de disposer des moyens de chauffage extérieurement contre l'enceinte intérieure de réaction, entre cette enceinte et une enceinte extérieure (ou chambre), ces moyens de chauffage chauffant la partie de l'enceinte intérieure où sont placés les substrats sur lesquels doivent être effectués les dépôts chimiques.

Un problème majeur reste malgré tout posé que ne résoud pas le document WO-87/01 738, à savoir l'altération constatée des propriétés électroniques des matériaux en formation, altération due notamment aux impuretés de vide résiduel régnant dans l'enceinte de réaction, ainsi qu'au dégazage des parois de cette dernière.

Dans le cadre de la présente demande, une solution a été trouvée à cette exigence en prévoyant de combiner un maintien à relativement basse température des parois de la chambre extérieure avec la création d'une dépression entre l'enceinte de réaction et ladite chambre, permettant d'aspirer vers l'extérieur de l'enceinte les impuretés présentes dans la zone de dépôt, tout en évitant que le dégazage des parois de la chambre viennent altérer la qualité des produits réalisés, autorisant ainsi la fabrication de cette chambre en des matériaux moins "sophistiqués",donc moins chers, sans exigences strictes quant à son dégazage.

De surcroît, grâce à une caractéristique complémentaire de l'invention, le risque de pénétration de certaines impuretés contaminantes dans l'enceinte de réaction pourra même être pratiquement éliminé.

Pour ce faire, il a été prévu dans l'invention de venir exercer sur la périphérie des porte-substrats (là où leur liaison avec les parois de l'enceinte de réaction est imparfaite) une force de poussée tendant à les presser étroitement de façon étanche contre ces mêmes parois. Pour exercer cette poussée, la solution consistant à utiliser des soufflets mécaniques extensibles dans la direction de la force à exercer est app arue comme la plus séduisante, compte tenu des conditions rigoureuses de fonctionnement de l'appreil. En pratique, ces soufflets s'étendront dans l'espace intérieur séparant la chambre étanche de l'enceinte de réaction et seront reliés à des conduits connectés à des moyens de mise sous pression, tels que un ou plusieurs compresseurs d'air.

De cette façon, les impuretés présentes dans la chambre ne pourront pénétrer dans l'enceinte, en particulier aux moments critiques, à savoir pendant la phase de dépôt des couches.

On notera également que par souci d'efficacité et pour assurer à l'appareil une certaine souplesse de mise en oeuvre, le chauffage de l'enceinte intérieure s'accompagnera avantageusement d'un maintien des parois de la chambre extérieure étanche à une température de l'ordre de 80°C, au maximum.

Avec un tel agencement, on pourra conserver autour de l'appareil un environnement acceptable, tout en évitant d'avoir recours à des mécanismes d'étanchéité, de mise sous vide, de protection thermique... très sophistiqués qu'il aurait été en pratique indispensable de prévoir compte tenu du vide poussé ($10^{-6}$ à $10^{-7}$ Pa environ) nécessaire en l'espèce pour éviter une contamination des matériaux déposés par plasma.

Revenant sur le principe de l'élévation de la température de l'enceinte, on notera que selon une caractéristique complémentaire de l'invention, celle-ci sera assurée par des moyens de chauffage qui pourront être disposés dans l'espace intermédiaire séparant l'enceinte de la chambre extérieure étanche.

Quant au maintien à une température convenable ( en pratique inférieure à 80°C environ) des parois de la chambre extérieure étanche, celui-ci pourra être assuré par des moyens formant écran thermique qui viendront alors recouvrir la plus grande partie au moins de la face intérieure des parois de la chambre.

A cette étape de la description, on remarquera qu'il s'agit là d'avantages importants par rapport aux machines du type "à ultravide" (UHV) actuellement utilisées pour la fabrication de certains semi-conducteurs. En effet, de façon à limiter les flux de dégazage, la technique UHV prévoit d'étuver jusqu'à 250°C, voire 450°C, l'ensemble de la machine que l'on doit pouvoir soumettre à un vide inférieur à $10^{-5}$ Pa (régulièrement de l'ordre de $10^{-7}$ Pa).

En outre, sur ces machines, compte tenu des conditions de pression et de température à supporter, toutes les parois doivent être réalisées en matériaux hautement résistants (acier inoxydable électropoli, molybdène...) et tous les joints d'étanchéité doivent être métalliques (cuivre, or...), ces joints ne pouvant d'ailleurs être utilisés qu'une seule fois. De plus, les problèmes de dilatation thermique et de jeu entre les pièces sont alors, comme on le comprend aisément, particulièrement difficiles à contrôler.

Les contraintes de fonctionnement des machines UHV sont donc sans commune mesure avec celles de l'appareil de l'invention.

L'invention, ses caractéristiques et avantages apparaîtront plus clairement à l'aide de la description qui va suivre faite en référence aux dessins annexés dans lesquels :

– la figure 1 montre schématiquement et en coupe transversale médiane l'appareil de l'invention,

– la figure 2 montre, une variante de réalisation de ce même appareil et,

– la figure 3 montre en vue partielle l'appareil de la figure 1 pourvu d'un moyen de réglage du débit de gaz qui circule dans l'enceinte de réaction.

Sur ces figures, l'appareil de production de couches amorphes qui fonctionne selon un processus de dépôt par plasma, est d'une façon générale, du même type que celui qui a été décrit dans la demande française précitée FR-A-2 589 168 à laquelle on pourra se reporter.

Cet appareil comprend donc une chambre extérieure étanche 2 qui peut supporter un vide partiel d'environ $10^{-4}$ à $10^{-5}$ Pa. A l'intérieur de la chambre 2 est logée une enceinte 3 relativement allongée. Dans cette enceinte, peut être créée une double zone de plasma 4, 4' entre une électrode centrale 5 et deux substrats 7 et 7'. L'électrode 5 s'étend sensiblement dans l'axe général 6 de l'enceinte et est reliée par sa tête 5' à une source haute tension. Des plaques 17, 17' porte-substrats sur lesquelles sont montés les substrats 7, 7' viennent prendre appui, vers leur périphérie en 17a, 17'a,respectivement,sur les parois latérales 13, 23 de l'enceinte,lesquelles se raccordent de façon étanche aux parois de fermeture avant 33 et arrière 43 sur lesquelles débouchent, également de façon étanche, respectivement des conduits 8 et 11.

Les substrats sont ici dirigés sensiblement parallèlement l'un à l'autre et font face à la zone de plasma.

Le conduit 8 qui débouche à l'extrémité longitudinale arrière de l'enceinte après avoir traversé en 12 de façon étanche la paroi de la chambre 2, alimente la zone de plasma en gaz réactifs de production des couches.

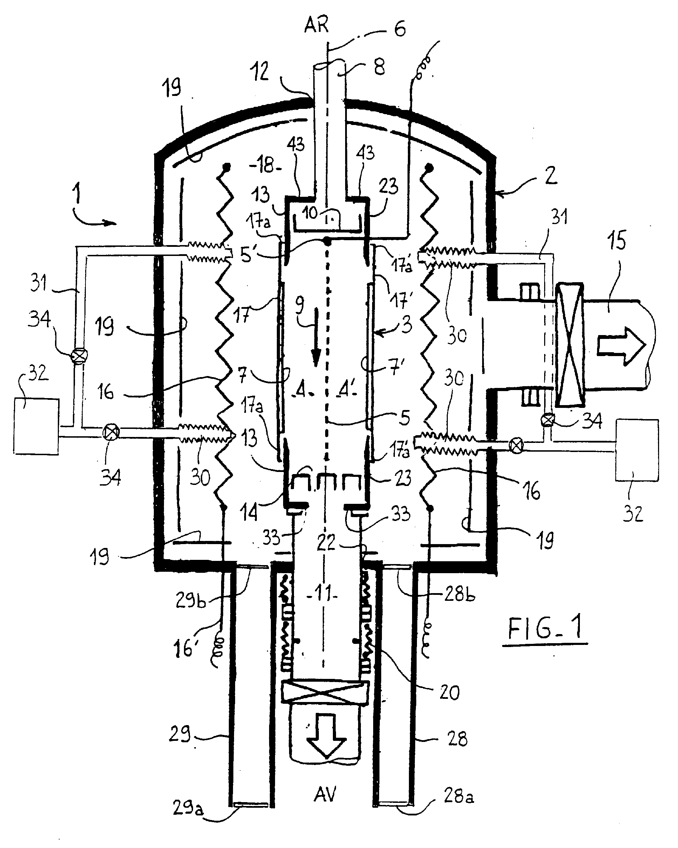

Sur la figure 1, on a repéré par les lettres AV et AR, les côtés respectivement avant et arrière de l'enceinte en faisant référence à la circulation des gaz réactifs dans l'appareil, telle que schématisée par la flèche 9.

Vers l'extrémité arrière de l'enceinte, les gaz réactifs rencontrent sur leur chemin un premier étranglement 10,ou répartiteur, destiné à améliorer la distribution des gaz dans l'enceinte.

Après que ces gaz aient séjourné en présence du plasma généré par la mise sous tension de l'électrode 5 et se soient,pour partie,déposés sur les substrats, la partie résiduelle non déposée est évacuée vers l'extérieur de l'enceinte par le conduit 11 qui est relié à l'enceinte vers son extrémité longitudinale avant et qui traverse de façon étanche, en 22, la paroi de la chambre 2.

Une pompe, telle qu'une pompe à dépression, pourra être utilisée pour aspirer la matière résiduelle à évacuer.

On notera que de façon à maintenir un débit et une pression de pompage relativement limitée, les gaz en circulation rencontrent, vers l'extrémité avant de l'enceinte, un second niveau d'étranglement repéré 14.

Comme connu en soi, la matière de production des couches sera un support, en général un gaz,admis à une pression d'environ $10^1$ Pa qui fournira aux régions de plasma les constituants élémentaires,lesquels, après décomposition du support par décharge électrique, viendront se déposer sur les substrats sous la forme de films minces. A titre d'exemple, le tétrafluorure de silicium et le silane pourraient être utilisés en tant que matière de production de couches de silicium. Par ailleurs, différents type de dopants pourraient être retenus.

Si l'on examine à nouveau la figure 1, on voit que la mise sous vide de la chambre extérieure étanche 2 qui entoure l'enceinte de dépôt est assurée par un conduit 15, lequel est relié à une pompe à vide (non représentée) de puissance adaptée pour assurer un vide d'environ $10^{-4}$ à $10^{-5}$ Pa.

Malgré, comme on l'a vu, les avantages qu'elles procurent, toutes ces caractéristiques connues ne permettent pas de limiter le flux de dégazage de l'enceinte 3 et des différents éléments qui y sont intégrés (substrats, électrode...).

C'est donc pour résoudre ce problème dans des conditions industriellement acceptables que l'invention prévoit notamment d'élever la température de l'enceinte par des moyens tels que des résistances en forme de rampe logées dans l'espace intermédiaire 18 qui sépare l'enceinte de la chambre. Ces résistances 16 sont reliées à des sources électriques adaptées et leurs fils d'alimentation repérés 16' traversent de façon étanche la chambre 2.

Les éléments chauffants retenus devront pouvoir porter les parois de l'enceinte 3 à une température comprise entre 100 et 300°C environ pendant la phase de dépôt des films sur les substrats. En pratique, dans des conditions habituelles de travail, la gamme des températures sera en fait comprise entre 150 et 250°C environ. Néanmoins, la limite supérieure pourrait être dépassée. En effet, plus on chauffera l'enceinte (sans aller bien entendu jusqu'à l'endommager par surchauffage), plus le flux de dégazage nocif pour la qualité électronique des semiconducteurs en formation diminuera.

On notera que dans un certain nombre de cas, il pourra être utile d'effectuer un préchauffage de l'enceinte à une température d'environ 300 à 350°C, avant d'y amener la matière de dépôt, laquelle pourrait avoir été également préchauffée à une température d'environ 50°C supérieure à la température nominale de dépôt.

Un tel préchauffage de l'enceinte permettra notamment d'assurer un décapage de surface limitant encore davantage le dégazage ultérieur des parois.

Dans le même esprit, on pourra également prévoir qu'à sa sortie de la chambre 2, le conduit 11 d'évacuation des matières résiduelles soit lui-même chauffé par des résistances 20, toujours de préférence à une température comprise entre 150 et 250°C environ.

Afin de renvoyer vers l'enceinte la chaleur rayonnée par les élements chauffants 16 et protéger thermiquement les parois de la chambre extérieure 2, de façon à la maintenir au maximum à une température d'environ 80°C, la solution préférée a été dans l'invention et tel qu'illustré aux figures, de recouvrir la plus grande partie, sinon la totalité, de la face intérieure des parois de la chambre 2 par des écrans thermiques 19. Ces écrans pourront notamment être réalisés en aluminium poli et présenter leur face de "miroir" dirigée vers l'intérieur de la chambre.

Eventuellement, d'autres types de moyens de refroidissement des parois de la chambre (par exemple par circulation d'un liquide de refroidissement le long de ces parois) pourraient venir compléter l'écran thermique, voire s'y substituer.

On aurait également pu prévoir des parois de chambre en matériaux réfractaires. Néanmoins, la combinaison des écrans thermiques et de parois de chambre métalliques (acier traité) est apparue comme techniquement la plus intéressante et industriellement la plus rentable.

Bien entendu, ce maintien à une température peu élevée des parois de la chambre ne va pas limiter particulièrement leur flux de dégazage. Ceci ne représente cependant pas, en l'espèce, un inconvénient du fait du différentiel de pression qui est établi entre l'enceinte et la chambre au cours du processus de dépôt.

Ceci étant, malgré cette mise en dépression de la chambre 2 par rapport à l'enceinte de réaction, il s'est avéré, comme on l'a dit, que des impuretés provenant de la chambre pénétraient dans l'enceinte et à la suite d'une décomposition dans la zone de plasma 4, 4′ pouvaient s'incorporer aux couches minces déposées sur les substrats, avec pour conséquence d'altérer la qualité électronique de ces couches.

Le manque d'étanchéité dans l'appui des plaques porte-substrats 17, 17′ sur leurs parois de réception 13, 23 est apparu comme étant la principale cause de la pénétration de ces impuretés.

Mais par contre, une série d'essais et d'analyses a montré qu'une étanchéité extrêmement stricte n'était malgré tout pas indispensable, le bénéfice procuré par cette mise en étanchéité des porte-substrats restant conditionné par le chauffage de l'enceinte de réaction.

Pour fixer les esprits, nous dirons que pour une enceinte 3 d'un volume de 0,03 m³, permettant de traiter deux substrats 7, 7′ d'environ 30 x 30 cm², le débit de fuite au niveau de la jonction entre les porte-substrats et les parois de l'enceinte devrait être inférieur à $10^{-3}$ m³/s environ, et de préférence se situer au-dessous de $0,3.10^{-3}$ m³/s environ. Ceci correspond sensiblement au débit de fuite autorisé par une fente d'environ 3 m de long sur $10^{-2}$ m de profondeur et 50 $\mu$ m ($50 \times 10^{-5}$ m) d'épaisseur.

Bien entendu, un tel ajustement aurait été tout à fait réalisable par des moyens mécaniques de fixation (vis, boulons) si les pièces avaient eu pour vocation d'être fixes.

Mais en l'espèce, les porte-substrats doivent pouvoir être remplacés. Leur mobilité est donc nécessaire.

C'est d'ailleurs à cet effet que l'appareil est, de manière classique, pourvu de deux sas 28, 29. Ces sas sont disposés contre la paroi de la chambre 2 et comportent chacun, comme connu en soi, d'une part une première porte d'accès, respectivement 28a et 29a, qui permet au sas de communiquer avec l'extérieur et, d'autre part, une seconde porte d'accès, respectivement 28b, 29b qui permet au sas de communiquer avec l'intérieur de la chambre 2. Grâce à ces sas, la mise en place et le retrait des porte-substrats peut s'effectuer dans les meilleures conditions. En pratique, des convoyeurs mécaniques sous vide (non représentés) assurent le transport des porte-substrats et permettent soit de récupérer les substrats sur lesquels se sont déposés les films, soit d'introduire et de mettre en place dans l'enceinte les substrats "vierges".

Compte tenu de la nécessaire amovibilité des porte-substrats, leur maintien en étanchéité contre les parois de l'enceinte par un moyen rigide de fixation (soudage, boulonnage...) ne pouvait donc être retenu.

C'est pourquoi on a imaginé dans l'invention de venir exercer mécaniquement une pression sur les porte-substrats de façon à les appliquer étroitement contre leurs parois de réception, et ce uniquement aux moments opportuns ; à savoir essentiellement pendant les phases de dépôt de films et éventuellement au cours des périodes de préchauffage de l'enceinte.

La solution pratique qui a été retenue est illustrée aux figures.

Il s'agit en l'espèce d'une série de soufflets métalliques 30 pneumatiques, rétractables qui sont disposés dans l'espace intérieur 18 séparant la chambre 2 de l'enceinte 3, de telle sorte qu'il puissent agir par leur extrémité libre sur la périphérie des porte-substrats pour les plaquer à volonté et de façon sensiblement étanche contre les parois latérales correspondantes 13, 23 de l'enceinte.

Pour leur manoeuvre, les soufflets 30 sont reliés à des conduits 31 traversant de façon étanche la paroi de la chambre 2 et qui sont eux-mêmes connectés à des moyens de mise en pression, tels que un ou plusieurs compresseurs d'air 32 permettant d'agir si nécessaire de façon indépendante sur chaque soufflet, par exemple par l'intermédiaire de vannes de régulation 34.

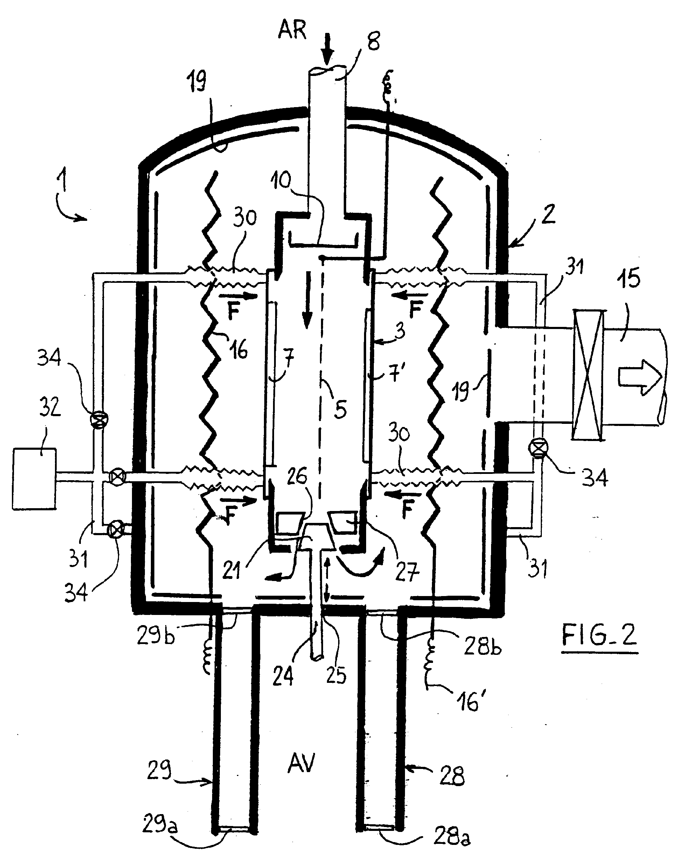

Ainsi, il suffira de faire varier la pression du gaz à l'intérieur des soufflets pour assurer soit leur extension (flèches F de la figure 2) et donc le maintien en étanchéité des porte-substrats sur l'enceinte, soit leur rétractation, autorisant alors le retrait de ces mêmes porte-substrats pour le remplacement et la collecte des substrats.

Reportons nous maintenant à la figure 2 où l'on voit illustrée une variante de réalisation de l'appareil de l'invention.

Dans cette variante, l'enceinte 3 débouche, vers son extrémité longitudinale avant directement dans le volume intérieur de la chambre 2. Il n'existe plus de conduit 11 d'évacuation de la matière résiduelle vers l'extérieur de la chambre. En d'autres termes, le conduit 15 de mise sous vide aspire ici non seulement les flux de dégazage des parois de l'enceinte et de la chambre, mais également les matières résiduelles qui circulent dans ladite enceinte.

Sur cette figure 2, on a également représenté un moyen de réglage de l'étranglement 14 de sortie de l'enceinte. Il s'agit ici d'un obturateur 21 en forme de tronc de cône pouvant venir s'engager sur des portées 26 de forme coopérante ménagées dans une pièce 27 fixée vers l'extrémité avant de l'enceinte. Une tige 24 de manoeuvre prolonge l'obturateur 21 vers l'extérieur de la chambre dont il traverse en 25 la paroi de façon étanche. Bien entendu, d'autres moyens de réglage, tels que des dispositifs à clapet pouvant être manoeuvrés de l'extérieur de la chambre, par exemple par une tringlerie de commande, auraient pu être envisagés. On comprend aisément que l'on aurait pu aussi prévoir ces mêmes moyens pour le réglage de l'étranglement 10 d'entrée dans l'enceinte et que, bien entendu, l'exemple de réalisation de la figure 1 aurait pu bénéficier également de la mise en place de tels moyens.

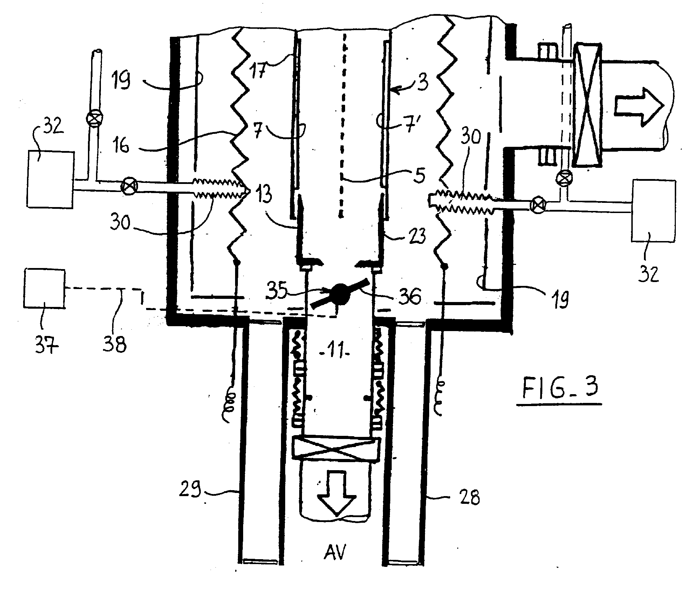

Figure 3 on a d'ailleurs représenté cette possibilité.

L'enceinte 3 est ici pourvue du côté de son extrémité où elle débouche sur le conduit d'évacuation 11, d'une électrovanne 35 dont le clapet 36 à ouverture réglable est placé sous la commande d'une unité de contrôle 37 à laquelle il est relié par un câble 38.

On notera encore que même si seule une disposition des substrats et de l'électrode, avec deux substrats et une électrode, a été envisagée, cela n'exclut en aucun cas d'autres dispositions, par exemple avec un double substrat central et, de part et d'autre, une électrode, ou encore une configuration non symétrique de l'enceinte du réacteur. Egalement, l'utilisation d'un seul porte-substrats ne portant qu'un substrat aurait pu être retenue.

Parmi des exemples de couches qui peuvent être déposées dans un réacteur à plasma du type ci-dessus décrit on peut citer en particulier :

Semi-conducteurs :

Silicium, germanium, carbone, et alliages des précédents.

Eventuellement arseniure de gallium. La morphologie des couches semi-conductrices peut être, suivant les conditions de dépôt et la nature du substrat
 – amorphe
 – microcristalline
 – monocristalline (épitaxie)

Isolants :

Oxyde de silicium, nitrure de silicium
Conducteurs (dans certains cas)
 – Aluminium, tungstène
 – Siliciure de tungstène
Les gaz d'apport sont des organométalliques, des fluorures volatils ou encore des métalcarbonyls.

## Revendications

1. Procédé pour conduire un appareil destiné à produire dans une enceinte où la pression est inférieure à la pression atmosphérique toutes sortes de couches minces à usage électronique ou optoélectronique telles notamment que des couches minces semi-conductrices amorphes ou cristallines, à l'aide d'un processus de dépôt par plasma, dans lequel procédé,
 – on place ladite enceinte (3) dans une chambre (2) étanche,
 – et on réalise un vide plus poussé dans la chambre que dans l'enceinte dans laquelle sont amenés des gaz réactifs de production des couches et d'où est évacuée, après un séjour en présence du plasma de déposition, la partie résiduelle et non déposée de ces mêmes gaz,
 caractérisé en ce que, de façon à améliorer les propriétés électroniques des couches déposées,
 – on chauffe les parois de l'enceinte (3),
 – et on maintient les parois de la chambre (2) à une température inférieure à celle de l'enceinte.

2. Procédé selon la revendication 1 caractérisé en ce que, pendant la phase de dépôt des couches, on maintient la température des parois de l'enceinte (3) entre 100 et 300°C environ, et de préférence entre 150 et 250°C.

3. Procédé selon la revendication 1 ou la revendication 2, caractérisé en ce qu'on chauffe l'enceinte (3) avant d'y amener la matière de production des couches.

4. Procédé selon l'une quelconque des revendications 1 à 3 pour conduire un appareil qui est pourvu d'au moins une plaque porte-substrats (17, 17'), ladite plaque porte-substrat(s) venant prendre appui sur une paroi latérale (13, 23) de l'enceinte de laquelle elle est amovible, caractérisé en ce qu'afin de limiter la pénétration dans l'enceinte (3) de certaines impuretés susceptibles d'altérer les propriétés électroniques des couches déposées, on vient exercer sur la plaque porte-substrats une force tendant à la presser étroitement, de façon sensiblement étanche, contre la paroi latérale (13, 23) de l'enceinte qui la reçoit.

5. Appareil pour produire toutes sortes de couches minces à usage électronique ou optoélectronique, telles notamment que des couches minces semi-conductrices amorphes ou cristallines, à l'aide d'un processus de dépôt par plasma, comprenant :
 – une enceinte (3) de dépôt dans laquelle règne une pression inférieure à la pression atmosphérique,
 – des moyens (5, 7, 7', 8) pour créer une zone (4, 4') de plasma dans l'enceinte, ces moyens comprenant au moins une électrode (5) reliée à une source de puissance électrique, au moins un substrat (7, 7') et des moyens (8) pour introduire des gaz réactifs de production des couches dans la zone (4, 4') de plasma,
 – des moyens (11, 15) pour évacuer, vers l'extérieur de l'enceinte (3) et après séjour dans la zone de plasma, la partie résiduelle des gaz réactifs qui ne s'est pas déposée,
 – et une chambre (2) étanche dans laquelle est logée ladite enceinte (3) et où règne une pression inférieure à celle de l'enceinte,

caractérisé en ce qu'il comprend en outre :

– des moyens (16) de chauffage pour chauffer l'enceinte (3) et les parois (13, 23, 17, 17') qui la limitent, ces moyens étant disposés dans l'espace (18) intermédiaire qui sépare l'enceinte de la chambre,

– et des moyens (19) pour maintenir les parois qui limitent la chambre (2) à une température inférieure à celle desdites parois de l'enceinte.

6. Appareil selon la revendication 5 caractérisé en ce que lesdits moyens (19) de maintien en température des parois de la chambre (2) comprennent des écrans thermiques recouvrant la plus grande partie au moins de la face intérieure des parois de cette chambre.

7. Appareil selon la revendication 5 ou la revendication 6 dans lequel l'enceinte (3) comprend deux étranglements de limitation de l'écoulement,dans l'enceinte, des gaz réactifs de production des couches, ces étranglements étant situés vers deux extrémités sensiblement opposées de l'enceinte où les gaz réactifs sont respectivement amenés et évacués, caractérisé en ce que l'un au moins desdits étranglements (10, 14) est à section réglable et peut-être commandé de l'extérieur de la chambre (2) par un moyen de réglage (24).

8. Appareil selon l'une quelconque des revendications 5 à 7 dans lequel le substrat (7, 7') est monté sur une plaque porte-substrats (17, 17') qui vient prendre appui de façon amovible sur une paroi latérale (13, 23) de l'enceinte, caractérisé en ce qu'il comprend en outre des moyens (30) pour appliquer de façon sensiblement étanche aux gaz ladite plaque porte-substrats (17, 17') contre ladite paroi latérale (13, 23) correspondante de l'enceinte.

9. Appareil selon la revendication 8 caractérisé en ce que lesdits moyens (30) d'application étanche de la plaque porte-substrats (17, 17') comprennent des soufflets métalliques (30) extensibles propres à venir exercer une pression sur ladite plaque pour la plaquer contre la paroi latérale (13, 23) correspondante de l'enceinte, lesdits soufflets s'étendant dans l'espace intérieur (18) qui sépare la chambre (2) de l'enceinte (3) et étant reliés à des conduits (31) d'alimentation en gaz, eux-mêmes connectés à des moyens (32) de mise sous pression des soufflets.

**Claims**

1. A method of operating an apparatus intended to produce in an enclosure in which the pressure is below atmospheric pressure all sorts of thin coatings for electronic or optoelectronic use, particularly such as thin amorphous or crystalline semi-conductive coatings, using a plasma deposition process in which process

– the said enclosure (3) is placed in a sealing-tight chamber (2)

– and in that a more extensive vacuum is created in the chamber than in the enclosure into which are brought reactive gases for producing the coatings and from which, after a period of dwell in the presence of the deposition plasma, the residual and non-deposited portion of the same gases is extracted,

characterised in that in order to improve the electronic properties of the deposited coatings,

– the walls of the enclosure (3) are heated

– and the walls of the chamber (2) are maintained at a temperature below that of the enclosure.

2. A method according to claim 1, characterised in that during the coating deposition phase, the temperature of the walls of the enclosure (3) is maintained at between 100 and 300°C approx. and preferably between 150 and 250°C.

3. A method according to claim 1 or claim 2, characterised in that the enclosure (3) is heated before the coating producing material is introduced therein.

4. A method according to any one of claims 1 to 3 for controlling an apparatus which is provided with at least one backing-carrier plate (17, 17'), the said backing carrier plate bearing on a lateral wall (13, 23) of the enclosure from which it can be detached, characterised in that in order to limit penetration into the enclosure (3) of certain impurities likely to alter the electronic properties of the deposited coatings, there is exerted on the backing carrier plate a force which seeks to press it closely and in substantially sealing-tight manner against the lateral wall (13, 23) of the enclosure which receives it.

5. An apparatus for producing all sorts of thin coatings for electronic or optoelectronic uses, particularly such as the thin amorphous or crystalline semi-conductive coatings, by means of a plasma deposition process, comprising:

– a deposition enclosure (3) in which there is a pressure which is below atmospheric pressure,

– means (5, 7, 7', 8) for creating a plasma zone (4, 4') in the enclosure, the said means comprising at least one electrode (5) connected to a source of electric power, at least one backing (7, 7') and means (8) for introducing reactive coating producing gases into the plasma zone (4, 4'),

– means (11, 15) for evacuating to the outside of the enclosure (3) and after a period of dwell in the plasma zone, the residual part of the reactive gases which have not been deposited,

– and a sealing-tight chamber (2) in which the said enclosure (3) is housed and in which there is a pressure which is below that of the enclosure,

characterised in that it further comprises:

– heating means (16) for heating the enclosure (3) and the walls (13, 23, 17, 17') which define it, the said means being disposed in the intermediate space (18) which separates the enclosure from the chamber,

– and means (19) of maintaining the walls which define the chamber (2) at a temperature which is less than that of the said walls of the enclosure.

6. An apparatus according to claim 5, characterised in that the said means (19) for maintaining the walls of the chamber (2) at a temperature comprise heat screens covering the major part at least of the inner face of the walls of the said chamber.

7. An apparatus according to claim 5 or claim 6 in which the enclosure (3) comprises two constrictions for limiting flow into the enclosure of coating producing reactive gases, the said constrictions being situated towards two substantially opposite ends of the enclosure at which the reactive gases are respectively introduced and drawn off, characterised in that at least one of the said constrictions (10, 14) is of regulable cross-section and may be controlled from outside the chamber (2) by a regulating means (24).

8. An apparatus according to any one of claims 5 to 7 in which the backing (7, 7′) is mounted on a backing carrier plate (17, 17′) which bears in removable manner on a lateral wall (13, 23) of the enclosure, characterised in that it comprises also means (30) for applying the said backing carrier plate (17, 17′) against the said corresponding lateral wall (13, 23) of the enclosure in a substantially gas-tight manner.

9. An apparatus according to claim 8, characterised in that the said means (30) of applying the backing carrier plate (17, 17′) in sealing-tight manner comprise metal extensible bellows (30) adapted to exert a pressure on the said plate so that it fits snugly against the corresponding lateral wall (13, 23) of the enclosure, the said bellows extending into the interior space (18) which separates the chamber (2) from the enclosure (3) and being connected to gas supply lines (31) which are themselves connected to means (32) for pressurising the bellows.

**Patentansprüche**

1. Verfahren zum Steuern einer Vorrichtung zur Herstellung jeglicher Art dünner Schichten für elektronische oder optoelektronische Verwendung, wie insbesondere amorphe oder kristalline Halbleiter-Dünnschichten, mittels eines Plasma-Ablagerungsprozesses in einem Raum, in dem der Druck geringer als Atmosphärendruck ist, wobei man bei diesem Verfahren

– diesen Raum (3) in einer abgedichteten Kammer (2) anordnet

– und in der Kammer ein höheres Vakuum als in dem Raum realisiert, in den Reaktionsgase zur Herstellung der Schichten eingeführt und aus dem, nach einer Verweilzeit in Gegenwart des Ablagerungsplasmas, der restliche und nicht abgelagerte Teil derselben Gase evakuiert wird,

dadurch gekennzeichnet, daß man, um die elektronischen Eigenschaften der abgelagerten Schichten zu verbessern,

– die Wände des Raumes (3) erwärmt

– und die Wände der Kammer (2) auf einer Temperatur unterhalb der des Raumes hält.

2. Verfahren nach Anspruch 1, dadurch gekennzeichnet, daß man während der Ablagerungsphase der Schichten die Temperatur der Wände des Raumes (3) ungefähr zwischen 100 ° und 300 °C, und vorzugsweise zwischen 150 ° und 250 °C hält.

3. Verfahren nach Anspruch 1 oder Anspruch 2, dadurch gekennzeichnet, daß man den Raum (3) erwärmt, bevor man ihm das Material zur Herstellung der Schichten zuführt.

4. Verfahren nach einem der Ansprüche 1 bis 3 zum Steuern einer Vorrichtung, die mit mindestens einer Substrate-Trägerplatte (17, 17′) versehen ist, wobei diese Substrate-Trägerplatte sich auf einer seitlichen Wand (13, 23) des Raumes abstützt, von der sie lösbar ist, dadurch gekennzeichnet, dass man zur Begrenzung des Eindringens bestimmter Verunreinigungen in den Raum (3), die geeignet sind, die elektronischen Eigenschaften der Ablagerungsschichten zu verändern, auf die Substrate-Trägerplatte eine Kraft ausübt, die sie fest und im wesentlichen dicht gegen die seitliche Wand (13, 23) des sie aufnehmenden Raumes drückt.

5. Vorrichtung zum Herstellen jeglicher Art dünner Schichten für elektronische oder optoelektronische Verwendung, wie insbesondere amorphe oder kristalline Halbleiter-Dünnschichten, mittels eines Plasma-Ablagerungsprozesses, umfassend:

– einen Ablagerungsraum (3), in dem ein gegenüber Atmosphärendruck niedrigerer Druck herrscht,

– Mittel (5, 7, 7′, 8) zur Schaffung einer Plasma-Zone (4, 4′) in dem Raum, wobei diese Mittel mindestens eine an eine elektrische Energiequelle angeschlossene Elektrode (5), mindestens ein Substrat (7, 7′) und Mittel (8) zum Einführen von Reaktivgasen für die Herstellung der Schichten in der Plasma-Zone (4, 4′) umfassen,

– Mittel (11, 15) zum Evakuieren des restlichen, nicht abgelagerten Teils der Reaktivgase aus dem Raum (3) nach außen und nach einer Verweilzeit in der Plasma-Zone,

– und eine abgedichtete Kammer (2), in der besagter Raum (3) angeordnet ist und in der ein gegenüber dem Druck des Raumes niedrigerer Druck herrscht,

dadurch gekennzeichnet, daß sie weiterhin:

– Erwärmungsmittel (16) zum Erwärmen des Raumes (3) und der ihn begrenzenden Wände (13, 23, 17, 17′), wobei diese Mittel in dem Zwischenraum (18), der den Raum von der Kammer trennt, angeordnet sind,
– und Mittel (19), um die die Kammer (2) begrenzenden Wände auf einer Temperatur unterhalb der der genannten Wände des Raumes zu halten, umfaßt.

6. Vorrichtung nach Anspruch 5, dadurch gekennzeichnet, daß die genannten Mittel (19) zur Aufrechterhaltung der Temperatur der Wände der Kammer (2) Wärmeschilde umfassen, die den größten Teil mindestens der Innenfläche der Wände dieser Kammer bedecken.

7. Vorrichtung nach Anspruch 5 oder Anspruch 6, bei der der Raum (3) zwei Einschnürungen zur Begrenzung der Strömung der Reaktivgase zur Herstellung der Schichten in dem Raum umfaßt, wobei diese Einschnürungen in Richtung zweier im wesentlichen einander entgegengesetzter Enden des Raumes, an denen die Reaktivgase zugeführt bzw. evakuiert werden, angeordnet sind, dadurch gekennzeichnet, daß wenigstens eine der Einschnürungen (10,14) mit einstellbarem Querschnitt versehen und ggf. von außerhalb der Kammer (2) her durch ein Verstellmittel (24) steuerbar ist.

8. Vorrichtung nach einem der Ansprüche 5 bis 7, bei der das Substrat (7, 7′) auf einer Substrate-Trägerplatte (17, 17′) angebracht ist, die sich lösbar auf einer seitlichen Wand (13, 23) des Raumes abstützt, dadurch gekennzeichnet, daß sie weiter Mittel (30) zur im wesentlichen gegenüber den Gasen dichten Anbringung der Substrate-Trägerplatte (17, 17′) auf der entsprechenden seitlichen Wand (13, 23) des Raumes umfaßt.

9. Vorrichtung nach Anspruch 8, dadurch gekennzeichnet, daß die Mittel (30) zur dichten Anbringung der Substrate-Trägerplatte (17, 17′) dehnbare metallische Bälge (30) umfassen, die geeignet sind, einen Druck auf die genannte Platte auszuüben, um diese gegen die entsprechende seitliche Wand (13, 23) des Raumes zu pressen, wobei die Bälge sich in dem inneren Zwischenraum (18) erstrecken, der die Kammer (2) von dem Raum (3) trennt, und mit Gas-Versorgungsleitungen (31) verbunden sind, die ihrerseits mit Mitteln (32) zur Druckbeaufschlagung der Bälge verbunden sind.

FIG. 1

FIG_2

FIG_3